# EUROPEAN PATENT SPECIFICATION

(11) **EP 1 219 956 B1**
(45) Date of publication and mention of the grant of the patent: **18.07.2007**
(21) Application number: 01127723.3
(22) Date of filing: 21.11.1997
(51) Int. Cl.: G01N 23/227, H01J 37/02, G01N 23/20

(54) **Method for providing a substantially uniform surface potential on an insulating specimen**
Verfahren zum Erreichen eines im Wesentlichen gleichförmigen Oberflächenpotentials eines isolierenden Objektes
Méthode pour réaliser un potentiel de surface quasiment uniforme sur un échentillon isolant

(30) Priority: 17.12.1996 US 33609 P; 12.11.1997 US 968454
(43) Date of publication of application: 03.07.2002
(62) Divisional of application: 97120498.7
(73) Proprietor: ReVera Incorporated, Sunnyvale, CA 94086 (US)
(72) Inventor: Larson, Paul E., Eden Prairie, MN 55344 (US); Kelly, Michael A., Portola Valley, California 94028 (US)
(74) Representative: Grünecker, Kinkeldey, Stockmair & Schwanhäusser Anwaltssozietät

(56) References cited:
- US-A- 4 680 467
- US-A- 5 315 113
- US-A- 5 432 345

## Description

This application claims the benefit of copending provisional application serial No. 60/033609. This invention relates generally to analysis of surfaces, particularly to electron and ion emission spectroscopy such as x-ray photoelectron spectroscopy and secondary ion mass spectroscopy, and more particularly to control of surface potential of insulating specimens being subjected to such spectroscopy.

### BACKGROUND

In an x-ray photoelectron spectroscopic (XPS) instrument, a beam of x-rays illuminates a portion of a specimen to cause electrons to be emitted, for example as disclosed in U.S. patent No. 5,315,113 (Larson et al.). These emissions are analyzed with an energy analyzer to determine the composition of the surface. However, with an insulating specimen, the electron emissions leave the surface positively charged in the region of the x-ray illumination. The positive charge varies across the surface, thereby affecting the emitted electron energies and trajectories, and introducing errors into corresponding analyses.

In secondary ion mass spectroscopy (SIMS) a surface is irradiated with positive ions so as to cause emission of atoms and ions from the surface. The incident ions cause a buildup of positive charge on an insulating specimen. As for XPS, such a charge introduces errors into analyses.

Various approaches to these problems include, at least for XPS, interposing a grid close to the sampie to smooth gradients in electrical potential, such as disclosed in U.S. patent No. 4,680,467 (Bryson). This introduces an interfering element and has limited applicability.

In another approach, the specimen is neutralized by flooding with low energy electrons. This provides a significant improvement, but generally results in nonuniform neutralization because an area larger than the region of photoemission is flooded, thereby supplying excess negative charge in the area outside of the photoelectron region. U.S. patent No. 5,432,345 ("Kelly patent", assigned to the present assignee) discloses smoothing the field gradients by discharging excess negative charge with irradiation of ultraviolet light or a beam of positive ions. This technique with radiation or ions can reduce the gradients quite significantly, but there remains some gradient with resulting effects on analyses. Also, the Kelly reference is directed primarily to ultraviolet radiation and gives few details in the use of positive ions. Ion sources are normally used for sputtering and the like, and typically produce ions with energies greater than 10 eV, although lower energy devices have been used experimentally.

A general problem with existing XPS instruments, even utilizing electron flooding, is sensitivity to neutralizer operating conditions. It has been difficult to obtain reproducible photoelectron peak positions and peak shapes.

### SUMMARY

An object of the invention is to effect a substantially uniform surface potential on an insulating specimen in an x-ray photoelectron or a secondary ion emission instrument in which the specimen has an irradiation region receptive of an energy beam to effect an emission from the specimen so as to cause positive charging of the irradiation region. Another object is to provide the substantially uniform surface potential with any remnant of gradient even less than provided by the aforementioned background art.

The foregoing and other objects are achieved, at least in part, in such an instrument with an apparatus that comprises an electron means for flooding an area of the specimen including the irradiation region with an electron beam of low energy electrons to neutralize the positive charging, such that the flooding causes negative charging of the flooding area outside of the irradiation region. The apparatus further comprises an ion means for directing positive ions onto at least a portion of the flooding area proximate the irradiation region to neutralize the negative charging in such portion.

According to one aspect of the invention, the electron means provides the electron beam with a low energy less than about 2 eV and an energy spread less than about 0.5 eV. In a preferable embodiment, the electron means comprises a thermionic electron emitter formed of an electron emitting material having a work function less than about 2 eV to effect the low energy of the electron beam.

According to another aspect, preferably in combination with the low energy electron beam, the ions substantially have a low ion energy less than 10 eV. In a further aspect, preferably in combination with the low energy electron beam and the low ion energy, the electron means is spaced at a distance from the specimen, the electron beam has a beam diameter at the specimen, and a ratio of the distance to the diameter is less than about 10.

### BRIEF DESCRIPTION OF THE DRAWINGS

**FIG. 1** is a schematic drawing illustrating an apparatus utilized in the invention.
**FIG. 2** shows the surface of a specimen of **FIG. 1**.
**FIG. 3** is a schematic drawing of an ion gun utilized in the apparatus of **FIG. 1**.
**FIG. 4** is a schematic drawing of an electron gun utilized in the apparatus of **FIG. 1**.
**FIG. 5** is a schematic drawing of an embodiment with substitution of a source of electrons in **FIG. 1** with a source incorporating an electron energy filter.

### DETAILED DESCRIPTION

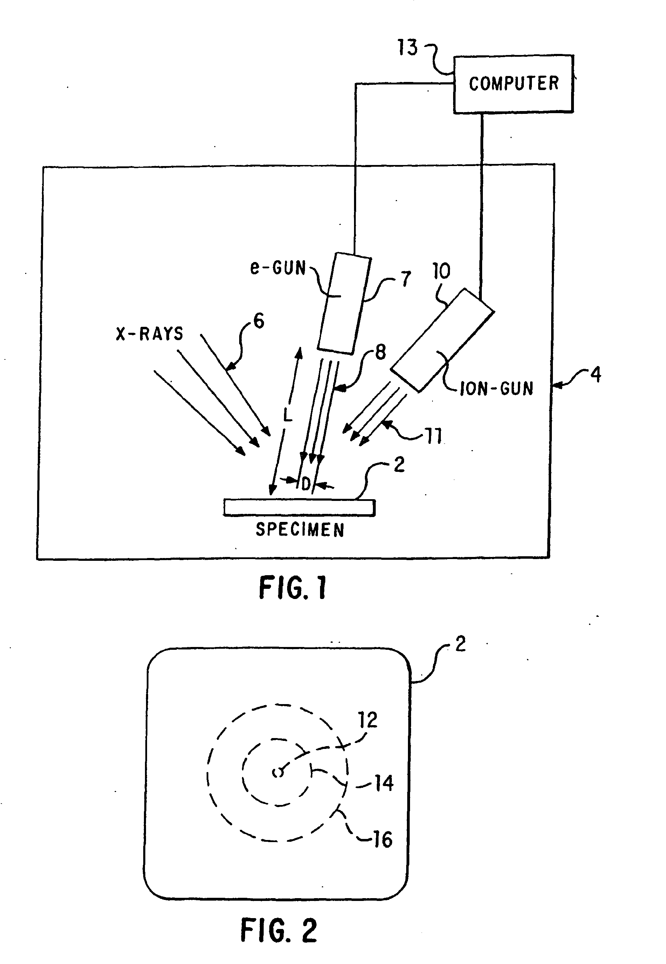

In one embodiment, an apparatus useful in the invention is utilized with an x-ray photoelectron (XPS) instrument for surface analysis, for example as disclosed in the aforementioned U.S. patent No. 5,513,113 ("Larson patent"). An insulating specimen 2 (**FIG. 1**) is mounted in the vacuum chamber of an XPS instrument **4.** X-rays **6** are directed conventionally to the specimen where they illuminate an irradiation region or spot **12** (**FIG. 2**) on the specimen to emit photoelectrons (not shown). An electron gun **7** emits low energy electrons **8** which flood the specimen. A source **10** of charged particles directs a beam of positive ions **11** to the specimen. The electron gun and the ion source are controlled advantageously by a computer **13** that conveniently may be the same as the system computer such as described in the Larson patent.

The emission of photoelectrons from the specimen surface causes positive charging of the irradiation region **12**. The area **14** flooded by the low energy electrons is generally larger than and includes the irradiation region, and thus neutralizes the positive charging but produces an excess of negative charge in the area outside the irradiation region. The ion beam **11** is directed onto at least a portion **16** of this area proximate the irradiation region to neutralize the negative charging. Although in this illustration the area of positive ions is shown to be larger than the electron flooded area **14**, the ion beam may be directed to an area equal to or smaller than the flooded area, provided a significant area around the irradiated region is covered by the ion beam to effectively minimize potential gradients in and around the irradiated region. In a typical XPS spectrometer, the x-ray irradiation region **12** may have a diameter of 1 mm or smaller, the electron area **14** may have a diameter of 1 to 10 cm, and the ion area **16** may have a diameter of 10 to 50 cm.

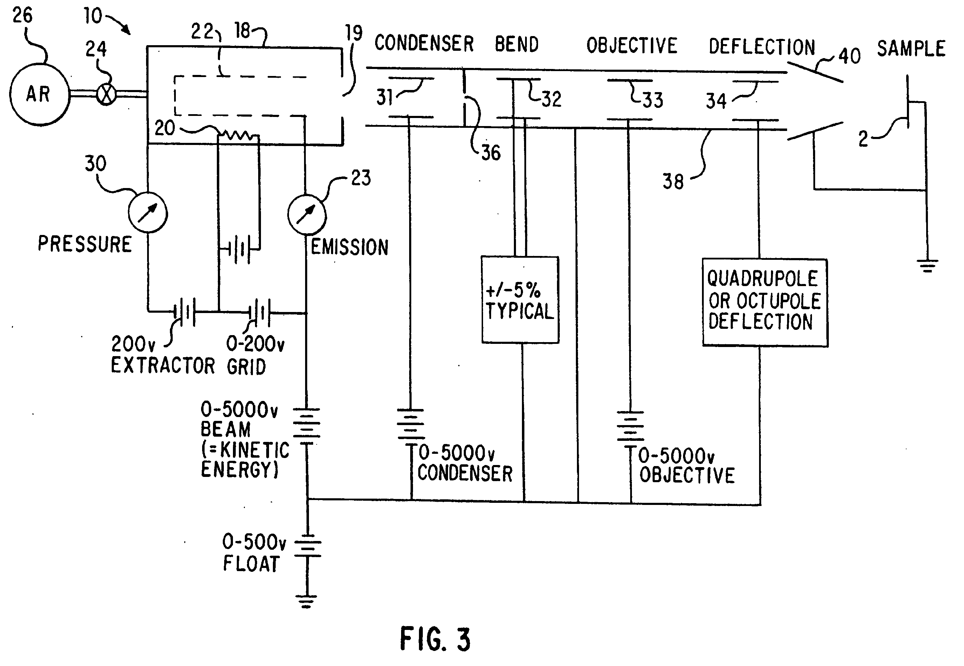

According to one embodiment of the present invention, the ions in the beam **11** are substantially with a low ion energy less than 10 eV. In a suitable ion gun **10** (**FIG. 3**), an ionization chamber **18** encloses a thermionic filament **20** emitting electrons that are accelerated by the positive potential of a tubular grid **22** to ionize argon gas therein. Emission current may be measured with an ammeter **23** to the grid. The gas has a regulated inlet **24** from a gas supply **26** to effect a chamber pressure of about 25 mPa. The pressure is detected by an ammeter **30** with the chamber **18** acting as an extractor electrode. In tandem after an opening **19** in the ionization chamber are a cylindrical condenser lens **31**, an aperture **36**, a pair of beam bending plates **32**, a cylindrical objective lens **33** and, optionally for steering, a cylindrical set of quadrupole or octupole deflection plates **34**. The tube **38** containing these elements is set at a relatively low float voltage. The ions are accelerated through the tube from the high voltage grid **22**, and slowed down to the desired energy in passing into a grounded conical exit ring **40** and thence to the grounded specimen **2**. The lens voltages track as a percentage of the beam voltage. There is a bend (not shown) of about 5° in the tube **38** at the location of the bending plates **32** so as to eliminate neutral atoms from the ion beam. Although the foregoing illustrates a suitable source of ions, any conventional or desired source of low energy ions that can be adapted into the instrument may be used.

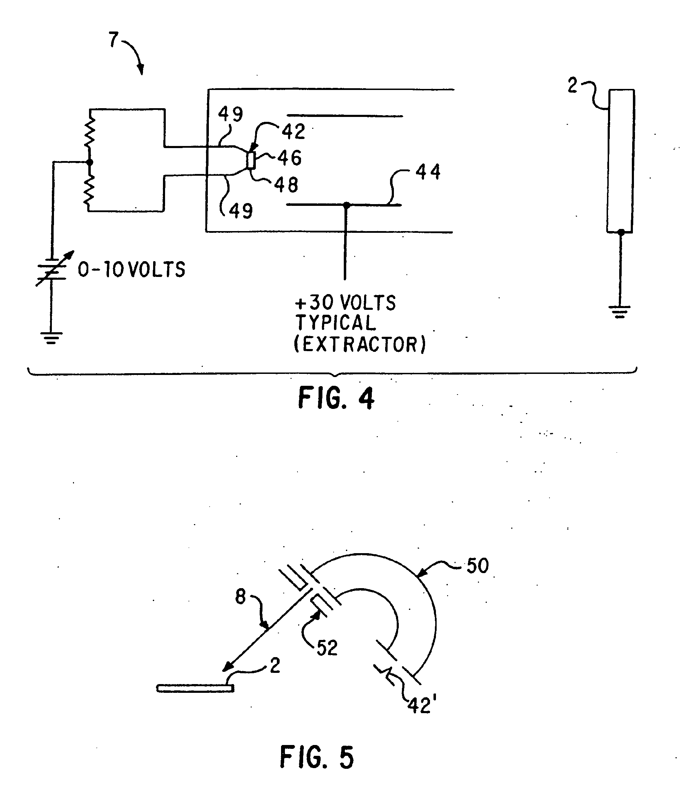

According to the invention the flooding electrons have a relatively narrow spread of energy, the spread being substantially less than about 0.5 eV, for example about 0.3 eV. Also, the electrons have a very low energy, less than 2 eV (compared with a spread of about 1 to 10 eV for conventional flooding). An electron gun **7** (**FIG. 4**) typically has a thermionic emitter **42** heated with an electrical current, with the emitted electrons being accelerated through a cylindrical extractor 44.

In a preferred means to achieve the desired energy spread, the emitter **42** is formed of an electron emitting material having a work function less than about 2 eV, for example 1 eV. For comparison, a conventional tungsten emitter has a work function of about 4.5 eV. With a low work function, the emitter is operated at lower temperature, thereby substantially reducing the width of the energy distribution and the fraction in the high energy tail of the Boltzman distribution. For example, the emitter may be formed of a film **46** of barium-strontium oxide on a platinum disk **48** heated by current in the supporting legs **49** welded to the disk. The film is similar to that previously formed on nickel cans utilized for emitters in vacuum tubes. A suitable emitter is a model ES-015 barium oxide disk cathode from Kimball Physics Inc., Wilton, NH.

Alternatively the desired energy spread may be achieved with an electron energy filter such as a hemispherical electrostatic analyzer **50** (**FIG. 5**) disposed between the electron source, e.g. a thermionic emitter **42'**, and the specimen, with one or more intermediate lens **52** as needed. Such filter may be any electrostatic or electromagnetic energy analyzer configured for the present application, for example being a cylindrical electrostatic analyzer, or a hemispherical electrostatic analyzer (as shown) of the type disclosed in the Larson patent.

The maximum current of the flooding electrons at the specimen is limited by space charge proximate the specimen, the maximum being inversely proportional to the square of the ratio **L/D** of the distance **L** of the gun from the specimen to the diameter **D** of the flooding electron beam at the specimen. The diameter is generally about the same as that at the gun exit. To maximize this current, the electron gun should be as close as practical to the specimen. It was determined that the ratio **L/D** preferably should be less than about 10, more preferably less than about 6, where **D** is assumed to be the beam diameter at the gun exit.

It is particularly advantageous to utilize at least two and preferably all of the aforedescribed embodiments in combination. Thus, in a preferred embodiment, the ion energies are substantially less than 10 eV, the flooding electrons have energies less than about 2 eV in a narrow energy spread of less than about 0.5 ev achieved with a low work function emitter, and the ratio of the electron gun distance to the beam diameter is less than about 10. More preferably the flooding electrons are effected with an electron emitter with a work function less than about 2 eV.

It has been found that the foregoing improvements effect a substantially more uniform potential than disclosed in the Kelly patent. Also, the instrument is significantly more robust and reliable than heretofore, in that a range of specimen types and surface areas can be analyzed without the previous variations in analytical results and sensitivity in setting electron flood current. The low electron energy and closer distance for the electron gun allow higher flooding current densities. Photoelectron density is up to about 40 nA/mm² for a focussed 10 micron diameter x-ray beam spot on an insulating specimen. It is desirable for the neutralizing electron current to be at least 10 time greater than the photoelectron current, and this can be achieved with.the combined improvements allowing 400 nA/mm².

The invention may similarly be utilized beneficially for the neutralization of insulating specimens in other analytical instruments which effect positive charging of the specimen surface, for example in secondary ion mass spectroscopy (SIMS) in which a surface is irradiated with positive ions. The introduction of electron flooding and low energy positive ions is effected in substantially the same manner as for XPS. In **FIG. 1**, the x-rays **6** are replaced with a beam of positive ions (which are separate from the neutralizing beam of ions **11**).

While the invention has been described above in detail with reference to specific embodiments, various changes and modifications which fall within the scope of the appended claims will become apparent to those skilled in this art. Therefore, the invention is intended only to be limited by the appended claims or their equivalents.

## Claims

1. A method for providing a substantially uniform surface potential on an insulating specimen in an analytical instrument, wherein the specimen has an irradiation region receptive of an energy beam to effect an emission from the specimen so as to cause positive charging of the irradiation region, the method comprising:
flooding an area of the specimen including the irradiation region with an electron beam (8) of low energy electrons to neutralize the positive charging such that the flooding causes negative charging of the flooding area outside of the irradiation region; and
directing positive ions (11) onto at least a portion of the flooding area proximate to the irradiation region to neutralize the negative charging in such a portion;
**characterized by**
the low energy electrons having an energy less than 2 eV and an energy spread less than 0.5 eV.

2. The method of claim 1,
**characterized by**
the ions substantially having an energy less than 10 eV.

3. The method of claim 1, further comprising:
providing an electron source (42) and an electron energy filter (50); and
arranging said electron energy filter (50) between said electron source (42) and said specimen to effect the low energy of said electron beam (8).

4. The method of claim 1, wherein the method further comprises providing a thermionic electron emitter (42) formed of an electron-emitting material having a work function less than about 2 eV to effect the low energy spread of the electron beam.

5. The method of claim 1, wherein the method further comprises providing the electron beam using a barium oxide cathode as the electron source (42).

6. The method of claim 1, further comprising an electron source; and providing a distance between said electron source (7) and said specimen, wherein the ratio of said distance to a diameter of said electron beam (8) is less than about 10.

7. The method of claim 6,
**characterized in that**
the ratio is less than about 6.

## Patentansprüche

1. Verfahren, um ein im Wesentlichen gleichförmiges Oberflächenpotential auf einer isolierenden Probe in einem analytischen Instrument bereitzustellen, worin die Probe ein Bestrahlungsbereich aufweist, der einen Energiestrahl aufnimmt, um eine Emission von der Probe zu bewirken, so dass der bestrahlte Bereich positiv aufgeladen wird, wobei das Verfahren umfasst:
Fluten eines Bereiches der Probe einschließlich des Bestrahlungsbereichs mit einem Elektronenstrahl (8) mit Niedrigenergieelektronen, um die positive Aufladung zu neutralisieren, so dass das Fluten eine negative Aufladung des gefluteten Bereichs außerhalb des Bestrahlungsbereichs verursacht; und
Richten von positiven Ionen (11) auf mindestens einen Teil des Flutungsbereichs in der Nähe des Bestrahlungsbereichs, um die negative Aufladung in diesem Bereich zu neutralisieren;
**dadurch gekennzeichnet, dass**
die Niedrigenergieelektronen eine Energie geringer als 2 eV und eine Energiever teilung von weniger als 0,5 eV aufweisen.

2. Verfahren nach Anspruch 1,
**dadurch gekennzeichnet, dass**
die Ionen im Wesentlichen eine Energie von weniger als 10 eV aufweisen.

3. Verfahren nach Anspruch 1, das weiterhin folgendes umfasst:
Bereitstellen einer Elektronenquelle (42) und eines Elektronenenergiefilters (50); und
Anordnen des Elektronenenergiefilters (50) zwischen der Elektronenquelle (42) und der Probe, um die niedrige Energie des Elektronenstrahls (8) zu bewirken.

4. Verfahren nach Anspruch 1, wobei das Verfahren weiterhin das Bereitstellen eines thermionischen Elektronenemitters (42) umfasst, der aus einem elektronenemittierenden Material mit einer Austrittsarbeit von weniger als ungefähr 2 eV hergestellt ist, um die niedrige Energieverteilung des Elektronenstrahls zu bewirken.

5. Verfahren nach Anspruch 1, wobei das Verfahren weiterhin das Bereitstellen des Elektronenstrahls unter Verwendung einer Bariumoxid Katode als Elektronenquelle (42) umfasst.

6. Verfahren nach Anspruch 1, das weiterhin folgendes umfasst:
eine Elektronenquelle; und Bereitstellen eines Abstandes zwischen der Elektronenquelle (7) und der Probe, wobei ein Verhältnis des Abstandes zu dem Durchmesser des Elektronenstrahls geringer als ungefähr 10 ist.

7. Verfahren nach Anspruch 6,
**dadurch gekennzeichnet, dass**
das Verhältnis kleiner als 6 ist.

## Revendications

1. Procédé permettant de fournir un potentiel de surface essentiellement uniforme sur un spécimen d'isolation dans un instrument analytique, dans lequel le spécimen présente une zone d'irradiation réceptive à un faisceau d'énergie afin d'assurer une émission à partir du spécimen afin d'entraîner le chargement positif de la zone d'irradiation, ce procédé comprenant les étapes suivantes :
couvrir une partie du spécimen, y compris la zone d'irradiation, d'un faisceau d'électrons (8) de faible énergie afin de neutraliser le chargement positif de sorte que cette opération de couverture entraîne un chargement négatif de la zone de couverture en dehors de la zone d'irradiation et
diriger les ions positifs (11) sur au moins une partie de la zone de couverture proche de la zone d'irradiation afin de neutraliser le chargement négatif dans une partie de ce type ;
**caractérisé en ce que**
les électrons de faible énergie présentent une énergie inférieure à 2 eV et une diffusion d'énergie inférieure à 0,5 eV.

2. Procédé selon la revendication 1
**caractérisé en ce que**
les ions présentent essentiellement une énergie inférieure à 10 eV.

3. Procédé selon la revendication 1 comprenant en outre les étapes suivantes:
fournir une source d'électrons (42) et un filtre d'énergie électronique (50) et à
agencer ledit filtre d'énergie électronique (50) entre ladite source d'électrons (42) et ledit spécimen afin d'appliquer la faible énergie dudit faisceau d'électrons (8).

4. Procédé selon la revendication 1 dans lequel le procédé comprend en outre une étape consistant à fournir un émetteur d'électrons thermo-ioniques (42) composé d'un matériel émetteur d'électrons disposant d'un travail d'extraction inférieur à environ 2 eV afin d'assurer la diffusion de faible énergie du faisceau d'électrons.

5. Procédé selon la revendication 1 dans lequel le procédé comprend en outre une étape consistant à fournir le faisceau d'électrons en utilisant une cathode d'oxyde de baryum comme source d'électrons (42).

6. Procédé selon la revendication 1 comprenant en outre une source d'électrons et présentant une distance entre ladite source d'électrons (7) et ledit spécimen, procédé dans lequel le rapport entre ladite distance et un diamètre dudit faisceau d'électrons (8) est inférieur à 10.

7. Procédé selon la revendication 6, **caractérisé en ce que**
le rapport est inférieur à environ 6.
